# EUROPEAN PATENT APPLICATION

(11) **EP 4 579 287 A1**
(43) Date of publication of application: **02.07.2025**
(21) Application number: 23857241.6
(22) Date of filing: 14.08.2023
(51) Int. Cl.: G01T 1/24, C30B 29/04

(54) **DIAMOND RADIATION DETECTOR**

(30) Priority: 26.08.2022 JP 2022134874
(71) Applicant: Orbray Co., Ltd., Tokyo 123-8511 (JP); Tohoku University, Sendai-shi, Miyagi 980-8577 (JP)
(72) Inventor: KIM, Seongwoo, Tokyo 123-8511 (JP); KOYAMA, Koji, Tokyo 123-8511 (JP); KASU, Makoto, Saga-shi, Saga 840-8502 (JP); HITOMI, Keitaro, Sendai-shi, Miyagi 980-8577 (JP)
(74) Representative: Papula Oy
(86) International application number: PCT/JP2023/029411
(87) International publication number: WO 2024/043128

(57) **Abstract**

There is room for improvement in the quality of diamond crystals used in radiation detectors produced using the conventional hetero-epitaxial method. The diamond crystal used for the radiation detector according to the present invention: is heteroepitaxially grown by means of chemical vapor deposition on a substrate comprising a material other than the diamond and having a plane orientation inclined by a predetermined off-angle from a just plane orientation; and has a crystallinity such that the full width half maximum of the diffraction peak of the (004) plane of the X-ray diffractometry represents a value shorter than or equal to 200 seconds.

## Description

### TECHNICAL FIELD

The present invention relates to a radiation detector using a diamond crystal for detecting radiation.

### BACKGROUND ART

Radiation detectors for detecting radiation, such as alpha (α)-rays, beta (β)-rays, γ (γ)-rays, and neutron rays, are used in various occasions, including medical applications and environmental measurements. There are various types of radiation detectors, including scintillation-based, GM tube-based, ionization chamber-based, and semiconductor-based radiation detectors, and they are properly used depending on applications. In recent years, there has been active research on semiconductor detectors with Ge or Si, which have excellent time responsibility and energy resolution and are capable of high-accuracy position detection. However, these semiconductor-based detectors need be cooled to low temperatures with liquid nitrogen when in use, which unfortunately makes them large and expensive as a whole.

In contrast, radiation detectors using diamond, a kind of wide bandgap semiconductors, have been attracting attention in recent years for their excellent characteristics, such as excellent radiation resistance and heat resistance, quick time response due to high carrier mobility, the atomic number close to effective atomic numbers of living bodies, and the ability to operate at room temperature.

The diamonds that have conventionally used in radiation detectors include high-quality diamonds carefully selected from natural single-crystal diamonds, high-quality single-crystal diamonds produced by High Pressure and High Temperature (HPHT) methods, and high-quality single-crystal diamonds grown by Chemical Vapor Deposition (CVD) methods using the high-quality single-crystal diamonds produced by the HPHT methods as seeds. The radiation detectors using these high-quality single-crystal diamonds have been demonstrated to have excellent characteristics (Non Patent Literature 1).

Initially, single-crystal diamonds were employed when diamond crystals were used in radiation detectors. However, because lenses cannot work for radiation and single-crystal diamonds are expensive and small in area, the detectors had the disadvantage that it was difficult to increase sensitivity. Although arranging small single-crystal diamond crystals in a tile-like pattern can increase the area, this approach complicates signal extraction and electrode structure, making integration difficult. The areas of polycrystalline diamonds can be increased more easily than those of single-crystal diamonds, and an example of developing a neutron detector using a boron-doped polycrystalline diamond can be found (Patent Literature 1). However, with polycrystalline diamonds, the effects of grain boundaries and defects prevent the above-mentioned excellent characteristics intrinsic to diamonds from being fully utilized, and thus achieved collection efficiency and resolution are both lower than those of single-crystal diamonds.

To fabricate high-sensitive radiation detectors, increasing the size of diamond crystals is essential. For this purpose, researches have become very active to produce a thin-film diamond on a surface of a crystalline diamond or other substrate material by a chemical vapor deposition (CVD) method using a gas as raw material, and to apply the thin-film diamond to a detection substrate in a radiation detector. Notably, the heteroepitaxial growth method in which diamond is grown on a non-diamond substrate, rather than the homoepitaxial growth method in which diamond is grown on a single-crystal diamond, allows for larger diamond substrates. For example, a crystal with a diameter of 2 inches has been achieved by forming a plurality of pillar-shaped diamonds made of diamond on a MgO substrate via an iridium (Ir) buffer layer by a microwave plasma CVD method, growing diamond crystals from the tips of the pillar-shaped diamonds, and coalescing the diamond crystals to form a diamond substrate layer (Patent Literature 2).

### CITATION LIST

PATENT LITERATURE 1: JP-A-05-150051
PATENT LITERATURE 2: JP-B-6142145
PATENT LITERATURE 3: JP-A-2011-155189

NON PATENT LITERATURE 1: Teruya Tanaka et.al, Diamond radiation detector made of an ultrahigh-purity type IIa diamond crystal grown by high-pressure and high-temperature synthesis, Review of Scientific Instruments Vol.72, 1406 (2001)
NON PATENT LITERATURE 2: S. Kim, R. Takaya, S. Hirano, and M. Kasu, Two-inch high-quality (001) diamond heteroepitaxial growth on sapphire (11-20) misoriented substrate by step-flow mode, Appl. Phys. Express, Vol. 14, 11551 (2021)

### SUMMARY OF INVENTION

### TECHNICAL PROBLEM

An example of a radiation detector using a diamond crystal produced by a heteroepitaxial method is disclosed in Patent Literature 3. The diamond layer grown on an Ir layer by the CVD method contains a high density of defects at the interface with the Ir layer. Therefore, after the diamond layer was detached from the Ir layer, the defect layer of the diamond layer on the Ir interface side was removed by 20 µm through mechanical polishing and dry etching, and a detector was then fabricated to detect α-rays.

However, if 20 µm of the defect layer of the diamond layer on the interface side with the growth substrate is removed, defects remain further inside (Patent Literature 3, Fig. 2). To eliminate the defects, a substantial portion of the thickness of the grown diamond layer needs to be removed through mechanical polishing or plasma etching, which significantly reduces the utilization efficiency of the crystal. Therefore, to obtain a high-quality diamond layer with low defect density without complicated processes for removing the defects in the diamond layer, the crystal needs to have sufficiently high quality at the completion of epitaxial growth.

### SOLUTION TO PROBLEM

The preset inventors have found that, by forming an Ir buffer layer on a substrate with a surface tilted at a small angle from the (11-20) plane of sapphire (α-Al₂O₃) and growing a diamond layer on the buffer layer, a diamond crystal grows in a step-flow mode, resulting in a high-quality crystalline diamond layer with minimal distortion (Non Patent Literature 2). Using this method, a free-standing, planar diamond crystal was produced and applied to a radiation detector. Consequently, it have found that, although being inferior to radiation detectors using small high-quality single-crystal diamond, response characteristics of the radiation detector is sufficient for practical use for γ-rays and other radiations.

A radiation detector of the present invention, in which diamond is used for a detector, is configured as follows.

The radiation detector includes: a diamond detector that includes the diamond in a planer shape having insulated side surfaces, and electrodes on opposite surfaces, and that generates charges upon radiation incidence; and a signal processing unit that digitally processes the charge used as an input signal, and
the diamond is a diamond crystal of a heteroepitaxially grown layer, and has crystallinity such that a full width half maximum of a diffraction peak of a (004) plane in X-ray diffractometry represents a value smaller than or equal to 200 seconds.

The diamond crystal is a heteroepitaxially grown layer on a substrate of a non-diamond material having a plane orientation with a small tilt angle, and is detached from the substrate and cut out.

The diamond crystal has a small tilt angle from a (001) plane orientation in a [110] direction.

The small tilt angle (off-angle) of the plane orientation of the diamond crystal is preferably from 7° to 10°.

A boron (B)-doped diamond layer may be further provided on a surface of the diamond crystal on which the radiation is incident to enhance sensitivity to neutrons.

The signal processing unit preferably includes a charge-sensitive preamplifier for amplifying the charge, a digitizer for capturing an output voltage signal, and a computer (PC) for obtaining an energy spectrum of the radiation.

The present invention also contains a method for fabricating the diamond radiation detector. The method includes:
producing a diamond crystal used for the diamond detector by a heteroepitaxial growth method with a small tilt angle from a (001) plane orientation in a [110] direction;
detaching the diamond crystal from the substrate and cutting into a planar, free-standing diamond crystal;
insulating side surfaces of the free-standing diamond crystal;
providing electrodes on both upper and lower surfaces of the free-standing diamond crystal to fabricate the diamond detector; and
connecting the diamond detector to a signal processing unit configured to digitally process an input signal, which is charges generated in the diamond crystal upon radiation incidence.

### ADVANTAGEOUS EFFECTS OF INVENTION

The diamond detector of the present invention can be easily fabricated using a free-standing heteroepitaxially grown diamond crystal that is superior in quality to conventional heteroepitaxially grown diamond crystals, and can provide a high-sensitive radiation detector at a lower cost than conventional radiation detectors using high-quality single-crystal diamonds.

### BRIEF DESCRIPTION OF DRAWINGS

[Fig. 1] Fig. 1 is a schematic diagram showing the structure of a diamond detector according to the present invention.
[Fig. 2] Fig. 2 is a schematic diagram showing the structure of a diamond detector for position detection according to the present invention.
[Fig. 3] Fig. 3 is a block diagram showing the overall configuration of a diamond radiation detector according to the present invention.
[Fig. 4] Fig. 4 is a graph showing the γ-ray spectra from the nuclides ⁶⁰Co, ¹³⁷Cs, and ¹³³Ba detected with the diamond radiation detector according to the present invention.
[Fig. 5] Fig. 5 is a graph showing the change in γ-ray spectrum of ¹³⁷Cs when the applied voltage to the diamond radiation detector according to the present invention is increased from 100 V to 500 V in increments of 100 V.
[Fig. 6] Fig. 6 is a graph showing the change in γ-ray spectrum of ¹³⁷Cs when the thickness of the diamond crystal according to the present invention is varied to 500 µm, 300 µm, and 100 µm for applied voltages 500 V, 300 V, and 100 V respectively, so that the internal electric field becomes constant.
[Fig. 7] Fig. 7 is a graph showing the γ-ray spectra of ⁶⁰Co, ¹³⁷Cs, and ¹³³Ba, and the background (BG) spectrum when the thickness of the diamond crystal according to the present invention is 100 µm and the applied voltage is 100 V.
[Fig. 8] Fig. 8 is a graph comparing the γ-ray spectrum obtained by the diamond radiation detector according to the present invention and the γ-ray spectrum obtained by a diamond radiation detector fabricated using a commercially available, highest-quality diamond crystal.
[Fig. 9] Fig. 9 is a graph showing the γ-spectra obtained by the radiation detectors according to the present invention using diamond crystals grown on substrates having plane orientations with different off-angles.
[Fig. 10] Fig. 10 is a plot of the X-ray diffraction peaks of the (004) plane and the (311) plane of diamond crystals produced with off-angles varied from 0° to 10°.

### DESCRIPTION OF EMBODIMENTS

Hereinafter, embodiments of the present invention will be described in detail with examples. The diamond crystal used in the present invention is obtained by forming an iridium (Ir) buffer layer on a substrate with a plane cut out at a small tilt angle from the (11-20) plane of sapphire in the [1-100]m direction or the [0001]c direction, and then growing the diamond crystal by a plasma CVD method using methane (CH₄) as a source gas at a substrate temperature of 1000 °C (Non Patent Literature 2). Using the substrate with an off-angle allows a diamond crystal to growth in the step-flow mode, in which atomic-sized steps are formed on the growth surface, and carbon atoms that have reached the surface diffuse laterally and are incorporated into the steps. As a result, a high-quality, 2 inch diameter diamond crystal with minimal defects is obtained. The diamond crystal grown in this manner has a crystal orientation with a small tilt angle from the (001) plane orientation in the [110] direction.

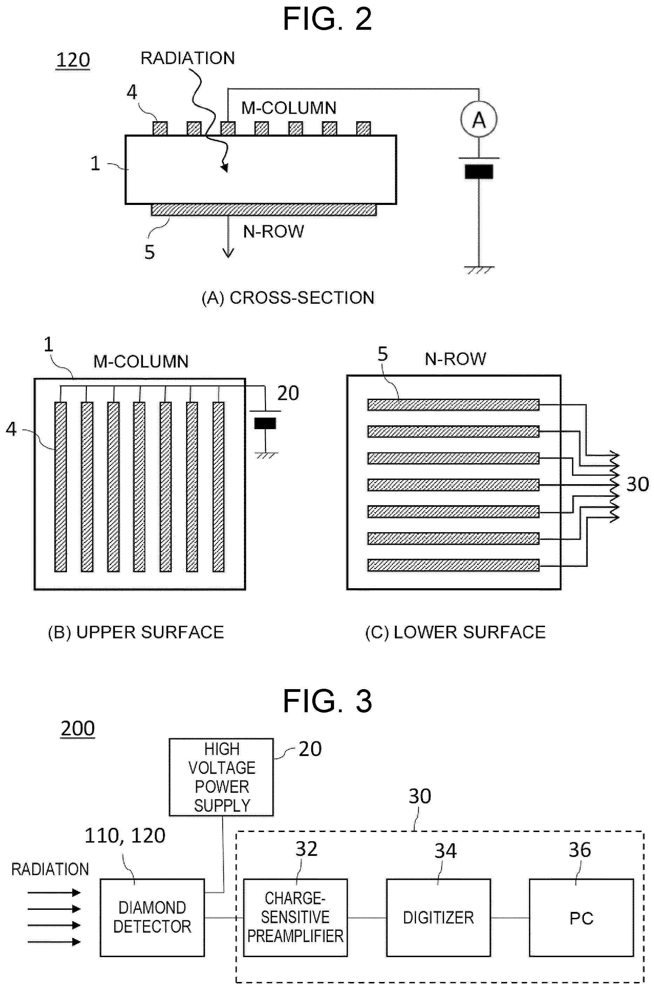

To evaluate the crystallinity of the grown diamond crystal, the diffraction peak of the (004) plane was measured by an X-ray diffraction method. As a result, the full width half maximum (FWHM) of the diffraction peak was 200 seconds or less, with the best crystal showing a small value of 98 seconds (Non Patent Literature 2). Although this value is slightly inferior to the FWHM of 50 seconds or less for the highest-quality homoepitaxially grown diamonds described above, it is a significant improvement compared to those of the conventional heteroepitaxially grown diamond crystals (300 seconds or less) (Patent Literature 2). Furthermore, spectrum measurement by Raman spectroscopy, which is another method for evaluating crystallinity, also showed a small FWHM value of 2.6 to 2.7 cm⁻¹ for the peak at 1332 cm⁻¹. This value is smaller than the value shown in Fig. 2 of Patent Literature 3 (>4), reflecting excellent crystallinity. The nitrogen concentration of 3 ppb or less, required for radiation detectors, is also satisfied.

In terms of crystal area, while commercially available, homoroepitaxially grown diamond crystals are 4.5 mm square, the diamond detector of the present invention can be fabricated using a diamond crystal of any size easily obtained by cutting out a wafer having a diameter of approximately 2 to 4 inches. In the following examples, a detector was fabricated using a crystal cut into 4 mm square with a laser. During the process, the cut surface becomes graphitized and conductive due to the heat of the laser. Therefore, the side surfaces were polished to insulate them. Furthermore, tensile stress is generated in the diamond crystal used in the present invention during the growth process, which makes it easier for the crystal to be detached from the substrate after the growth. As a result, a free-standing, planer diamond crystal can be obtained through a simple process.

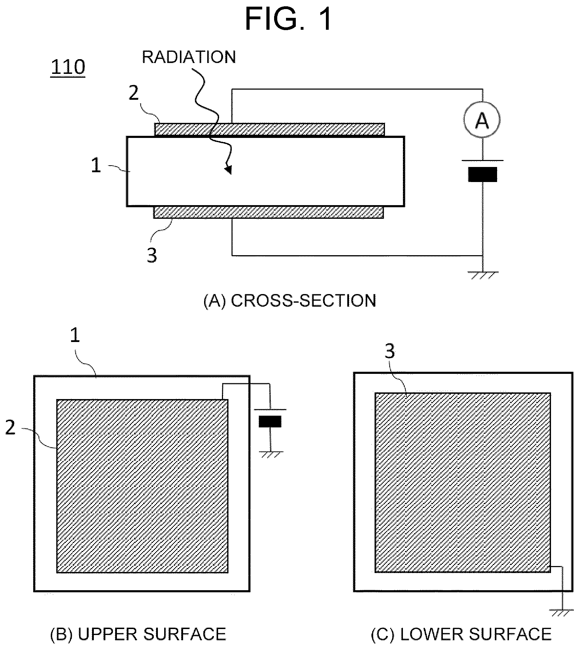

Figure 1 is a schematic configuration diagram of a first diamond detector 110 used in a radiation detector of the present invention. (A) is a cross-sectional view of the detector that is provided with gold (Au) or titanium/gold (Ti/Au) electrodes 2, 3 on both the upper and lower surfaces of a free-standing diamond crystal 1 with 4 mm square and 100-500 µm thick. When a high DC voltage is applied to the upper and lower electrodes, electron-hole pairs are generated in the diamond crystal by absorbed radiation. The charges reach the respective electrodes due to the electric field, and the amount of charge is measured.

Figure 2 is a schematic configuration diagram of a second diamond detector 120 used in a radiation detector for position detection of the present invention. (A) is a cross-sectional view of the detector that is provided with Au or Ti/Au electrodes 4, 5 on both the upper and lower surfaces of the free-standing diamond crystal 1 with 4 mm square and 100-500 µm thick, like the first diamond detector 110. When a high DC voltage is applied to the upper and lower electrodes, electron-hole pairs are generated in the diamond crystal by absorbed radiation. The charges reach the respective electrodes due to the electric field, and the amount of charge is measured. As shown in (B) and (C), the upper electrodes 4 and the lower electrodes 5 on the diamond crystal are respectively arranged as parallel lines and the directions of the parallel lines on the upper and lower electrodes are perpendicular to each other, forming an N-row, M-column matrix configuration. Electrons and holes are generated by the absorbed radiation, and sent as charge signals from the electrodes at the positions (N, M) where they have reached due to the electric field to a signal processing unit 30 (Fig. 3). This allows for the detection of the incident position of the radiation. The numbers of N and M can be adjusted to optimize the spatial resolution.

The diamond detectors 110 and 120 of the present invention can also detect neutron rays. In such cases, a layer containing elements such as boron (¹⁰B) or lithium (⁶Li) is provided on the neutron incidence surface side as a neutron converter layer, which allows for the conversion of neutrons into secondary radiation or recoil particles and detection of them. Preferably, forming a boron-doped diamond layer allows the converter layer to be uniformly formed on the incidence surface, eliminating the loss of charge collection.

A diamond radiation detector 200 of the present invention is consisting of the diamond detector 110 or 120, a high voltage power supply 20, and the signal processing unit 30 for digitally processing detection signals. The block diagram of the detector is shown in Fig. 3. A high DC voltage is applied between the upper and lower electrodes 2, 3 or electrodes 4, 5 of a diamond detector 10 with the high-voltage power supply 20, and the induced charge generated through the absorption of radiation is extracted from the electrodes. The extracted charge is used as an input signal and amplified in a charge-sensitive preamplifier 32, and then is output as a voltage signal. Subsequently, the signal waveform is captured by a digitizer 34 and digitally filtered in a computer (PC) 36 for waveform shaping and pulse height analysis. The wave height values for each channel are obtained to display an energy spectrum. The configuration for converting the input charge signal into the energy spectrum is not limited to the above example, and any configuration can be used.

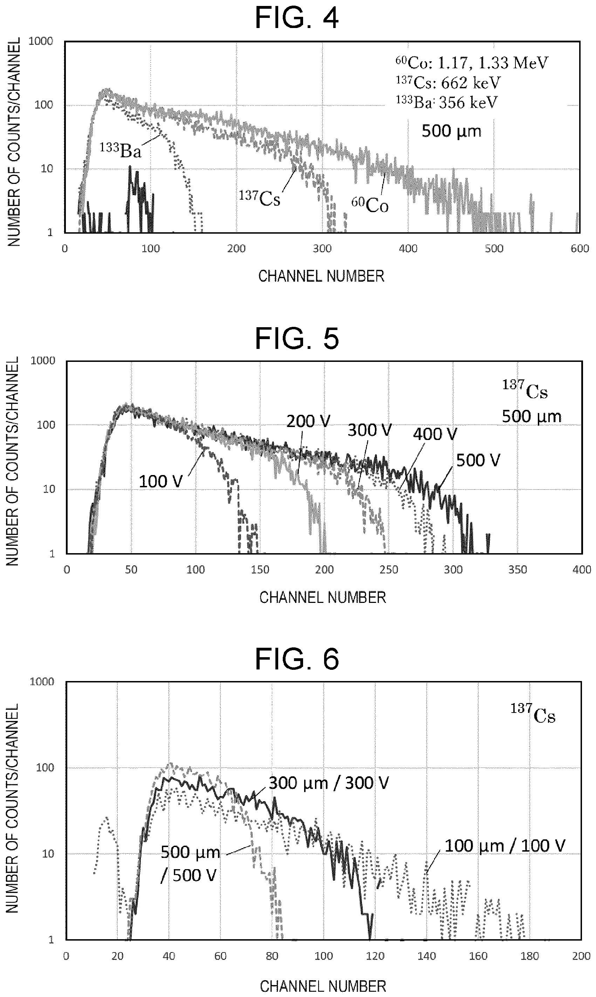

As an example of performance evaluation of the diamond radiation detector, γ-rays were detected. The result is shown in Fig. 4. The thickness of the diamond crystal is 500 µm and the applied voltage is 500 V. The vertical axis represents the logarithmic representation of the number of counts per channel corresponding to the signal strength. The horizontal axis represents the channel number, proportional to the energy of γ-rays. It was found that the nuclides ⁶⁰Co (1.17, 1.33 MeV), ¹³⁷Cs (662 keV), and ¹³³Ba (356 keV), which are typical γ-ray sources having different energies, can be clearly discriminated.

Figure 5 shows changes in γ-ray spectrum of ¹³⁷Cs when the applied voltage to the detector having a 500 µm thick diamond crystal same to Fig. 4 is increased from 100 V to 500 V in increments of 100 V. It was found that, as the applied voltage is increased, the charge collection efficiency can be improved.

Figure 6 shows changes in γ-ray spectrum of ¹³⁷Cs when the thickness of the diamond crystal is varied. The applied voltages are 500 V, 300 V, and 100 V for the thicknesses of 500 µm, 300 µm, and 100 µm, respectively, so that the internal electric field becomes constant at 1000 V/mm. It was found that even at the constant electric field strength, as the thickness of the diamond crystal is reduced, the wave height value was increased and the charge collection efficiency was improved. Furthermore, reducing the thickness of the diamond crystal provides significant advantages to the production cost due to reduced crystal growth time.

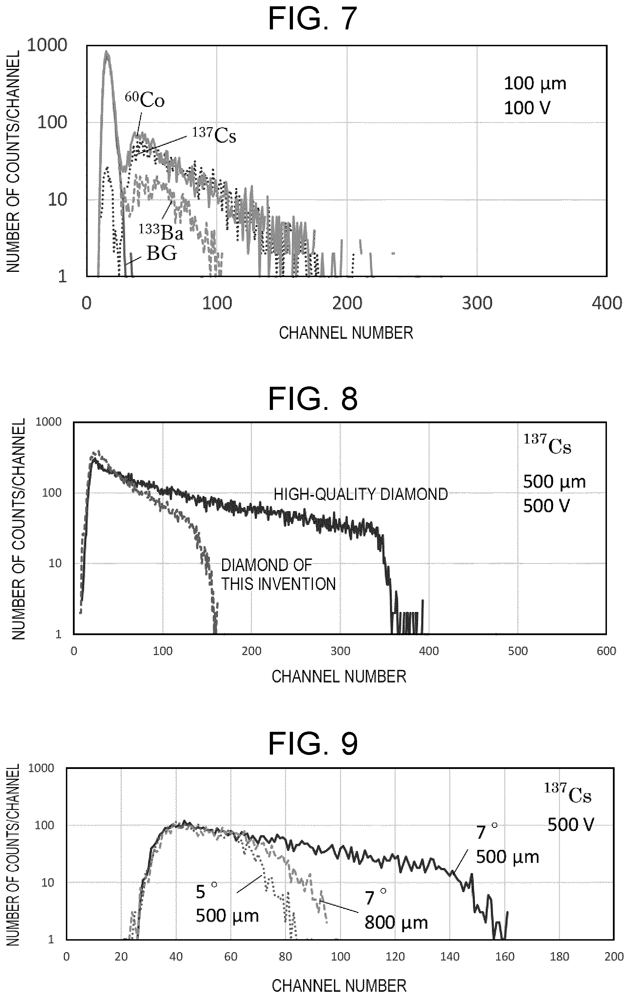

Figure 7 shows the γ-ray spectra of ⁶⁰Co, ¹³⁷Cs and ¹³³Ba, and the background (BG) spectrum when the thickness of the diamond crystal is 100 µm and the applied voltage is 100 V. Because reducing the thickness of the diamond layer decreases the absorption amount of y-ray into the diamond layer, the detected γ-ray counts for all nuclides are decreased. In measuring α-rays, charged particles, or neutrons, γ-rays can be noise, and the output γ-rays thus need to be suppressed. As shown in Fig. 6, reducing the layer thickness to 100 µm or less improved the charge collection efficiency, which produces an effect of realization of a high S/N detector for measuring α-rays, charged particles, or neutrons. In this way, the thickness of the diamond layer can be adjusted depending on the type of radiation to be measured.

The γ-ray spectrum obtained by the diamond detector used in the present invention was compared with the γ-ray spectrum obtained by a diamond detector having a similar structure and fabricated using a commercially available, highest-quality single-crystal diamond produced by a homoepitaxial growth method (made at Element Six). The result is shown in Figure 8. Both diamond single-crystals are 500 µm in thickness, and the applied voltage is 500 V. Although the wave height value of the diamond detector used in the present invention is inferior to that of the detector using homoepitaxially grown diamond, it was found that the diamond detector used in the present invention has sufficient performance for a general radiation detector.

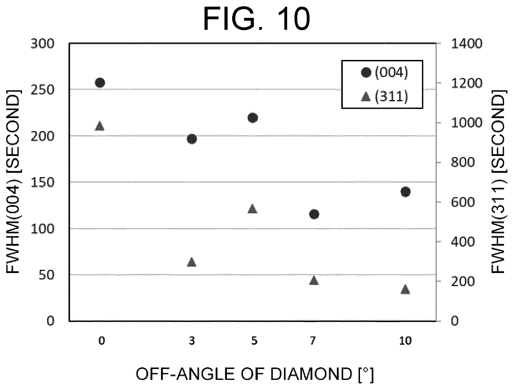

Figure 9 shows the γ-ray spectra of ¹³⁷Cs obtained by the detectors using diamond crystals grown on substrates with different off-angles. The applied voltage is 500 V. When comparing the diamond detectors having the same thickness (500 µm), the diamond crystal with an off-angle of 7° shows better charge collection than the diamond crystal with an off-angle of 5°. Even for the off-angle of 7°, increasing the thickness to 800 µm increases the charge transfer distance, decreasing the wave height value. The off-angle dependency is considered to correspond to the result shown in Fig. 3(a) of Non Patent Literature 2, in which the off-angle of 7° shows smaller FWHM values of the diffraction peaks for the (004) plane and the (311) plane in X-ray diffraction than the off-angle of 5°, and thus has better crystallinity. Fig. 10 is a plot of the measurement of the FWHMs of the X-ray diffraction peaks for the (004) plane and the (311) plane for diamond crystals produced with off-angles varied from 0° to 10°. As the off-angle increases from 0°, the FWHM tends to decrease. In the measurement range, the peaks of the (004) plane and the (311) plane are saturated to their respective small values at 7 to 10°, which indicates that the crystallinity is improved. Therefore, the off-angle of the diamond crystal used in the radiation detector of the present invention is preferably 7 to 10°.

Although the present invention has been described based on the above embodiments, the present invention is not limited to them, and various changes and modifications can be made within the spirit of the present invention and the scope of the appended claims.

### REFERENCE SIGNS LIST

- 1: diamond crystal
- 2, 4: upper electrode
- 3, 5: lower electrode
- 20: high voltage power supply
- 30: signal processing unit
- 32: charge-sensitive preamplifier
- 34: digitizer
- 36: computer (PC)
- 110: diamond detector
- 120: diamond detector for position detection
- 200: diamond radiation detector

## Claims

1. A radiation detector in which diamond is used for a detector, the radiation detector comprising:
a diamond detector that includes a diamond in a planer shape having insulated side surfaces, and electrodes on both upper and lower surfaces, and that generates charges upon radiation incidence; and a signal processing unit that digitally processes the charges as an input signal, and
wherein the diamond is a diamond crystal of a heteroepitaxially grown layer, and has crystallinity such that a full width half maximum of a diffraction peak of a (004) plane in X-ray diffractometry represents a value smaller than or equal to 200 seconds.

2. The radiation detector according to claim 1, wherein the diamond crystal is a heteroepitaxially grown layer on a substrate of non-diamond material with an off-angle, and is detached from the substrate and cut into a planar, free-standing diamond crystal.

3. The radiation detector according to claim 2, wherein the diamond crystal has a small tilt angle from a (001) plane orientation in a [110] direction.

4. The radiation detector according to claim 3, wherein an off-angle being the small tilt angle of the plane orientation of the diamond crystal is from 7° to 10°.

5. The radiation detector according to claim 4, wherein a boron (B)-doped diamond layer is further provided on a surface of the diamond crystal on a side where the radiation is incident.

6. The radiation detector according to claim 1 or 5, wherein the signal processing unit includes a charge-sensitive preamplifier for amplifying the charge, a digitizer for capturing an output voltage signal, and a computer for obtaining an energy spectrum of the radiation.

7. A method for fabricating a diamond radiation detector comprising a diamond detector in which diamond is used for a detector, the method comprising:
producing a diamond crystal used for the diamond detector by a heteroepitaxial growth method with a small tilt angle from a (001) plane orientation in a [110] direction;
detaching the diamond crystal from a substrate and cutting into a planar, free-standing diamond crystal;
insulating side surfaces of the free-standing diamond crystal;
providing electrodes on both upper and lower surfaces of the free-standing diamond crystal to fabricate the diamond detector; and
connecting the diamond detector to a signal processing unit configured to digitally process an input signal, which is charges generated in the diamond crystal upon radiation incidence.

8. The method for fabricating a diamond radiation detector according to claim 7, wherein an off-angle being the small tilt angle of the plane orientation of the diamond crystal is from 7° to 10°.

9. The method for fabricating a diamond radiation detector according to claim 8, wherein the diamond crystal has crystallinity such that a full width half maximum of a diffraction peak of a (004) plane in X-ray diffractometry represents a value smaller than or equal to 200 seconds.

10. The method for fabricating a diamond radiation detector according to claim 9, the heteroepitaxial growth method is a plasma chemical vapor deposition method using methane (CH₄) as a source.

11. The method for fabricating a diamond radiation detector according to any one of claims 7 to 10, wherein a boron (B)-doped diamond layer is further provided on a surface of the diamond crystal on which the radiation is incident.
